(19) Europäisches Patentamt
European Patent Office
Office européen des brevets

(11) Publication number: 0 191 882 B1

(12) **EUROPEAN PATENT SPECIFICATION**

(45) Date of publication of patent specification: 07.06.89

(51) Int. Cl.⁴: B 23 K 35/22, H 05 K 3/34

(21) Application number: 85101909.1

(22) Date of filing: 21.02.85

# (54) Method for soldering an electrical product.

(43) Date of publication of application: 27.08.86 Bulletin 86/35

(45) Publication of the grant of the patent: 07.06.89 Bulletin 89/23

(84) Designated Contracting States: DE FR GB

(56) References cited:
EP-A-0 043 224
US-A-2 740 193
US-A-4 240 945

(73) Proprietor: ASAHI GLASS COMPANY LTD.
No. 1-2, Marunouchi 2-chome
Chiyoda-ku, Tokyo (JP)

(73) Proprietor: SEIMI CHEMICAL COMPANY LTD.
No.2-10, Chigasaki 3-chome
Chigasaki-shi Kanagawa-Ken (JP)

(72) Inventor: Ohotoshi, Sachio
No. 543, Sanmai-cho Kanagawa-ku
Yokohama-shi Kanagawa-ken (JP)
Inventor: Hase, Fumio
2069-1, Kamigo-cho
Totsuka-ku Kanagawa-ken (JP)

(74) Representative: Wächtershäuser, Günter, Dr.
Tal 29
D-8000 München 2 (DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 191 882 B1

## Description

The present invention relates to a method for soldering an electrical device, wherein a coating of a specific fluoro compound is formed along the peripheral portion around the soldering portion to prevent the soldering flux from penetrating to or depositing on said peripheral portion.

For soldering various parts, such as switches, capacitors, connectors or resistors, to a printed circuit board, or an integrated circuit (IC) to an IC socket, it is common to employ flux pretreatment to improve the solderability. Such a flux contains an acidic component or non-conductive component, and if it deposits on a portion other than the soldering portion, it is likely to cause corrosion or conduction failure. Accordingly, it is extremely important to restrict the application of the flux treatment to the necessary portion. There has been proposed to use a masking tape which is designed to protect a non-soldering portion and to be peeled off after the soldering operation. However, this is a major factor which prevents the automation of the soldering treatment. In the case of a printed circuit board, soldering is frequently applied to through-holes, and the flux is likely to penetrate to the interior of the electrical device through such through-holes. Therefore, it is required not only to prevent the deposition of the flux but also to prevent the penetration of the flux.

Accordingly, it is an object of the present invention to provide a method for soldering an electrical device, whereby the soldering flux is prevented from penetrating to or depositing on the peripheral portion around the soldering portion.

Namely, the present invention provides a method for soldering an electrical device with a soldering flux, wherein an aqueous dispersion or an organic solvent solution of a compound containing a polyfluoroalkyl or polyfluoroether group having from 4 to 21 carbon atoms is applied to a peripheral portion around the soldering portion and dried to form a coating of said compound so as to prevent the soldering flux from penetrating to or depositing on said peripheral portion.

Now, the present invention will be described in detail with reference to the preferred embodiments.

As the compound containing a polyfluoroalkyl or polyfluoroether group having from 4 to 21 carbon atoms (hereinafter referred to simply as "$R_f$ group"), there may be mentioned a compound represented by the following formula I (hereinafter referred to as a "compound I"), a homopolymer of an unsaturated ester containing a $R_f$ group, or a copolymer of unsaturated esters containing different $R_f$ groups (hereinafter referred to as a "compound II"), or a copolymer of an unsaturated ester containing a $R_f$ group with other copolymerizable compound (hereinafter referred to as a "compound III").

$$[R_fA(X)_n]_mZ \qquad (I)$$

In the above formula I, $R_f$ is a straight chain or branched polyfluoroalkyl group having from 4 to 21 carbon atoms or an aliphatic, aromatic or cyclic polyfluoroether group having from 4 to 21 carbon atoms. The compound may contain a hydrogen atom or a chlorine atom at its terminal. However, $R_7$ is preferably a straight chain perfluoroalkyl group or an aliphatic perfluoropolyether group. A is CO, $SO_2$, COO, or $-(CH_2)_p-$ or $-(CH_2)_p-O$ where p is from 0 to 10. X is

$NR^1C_2H_4O$, $N(C_2H_4O)_2$, $-(CH_2-CH)-$, COO, $NR^1(CH_2)_qNR^2C_2H_4O$,

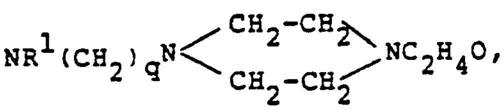, 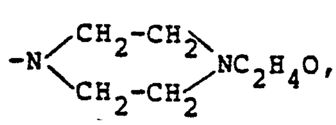, $-(C_2H_4O)_q-$ or $-(C_3H_6O)_q-$

where q is from 1 to 10, and each of $R^1$ and $R^2$ is a hydrogen atom, an alkyl group or an aryl group. n is 0 or 1. When n = 0, X does not exist. m is from 1 to 4, and Z is a 1 to 4 valent organic group depending upon m. Z may be

$NR^1(C_2H_4N)_qR^1$, $NR^1(C_3H_6N)_qR^1$, H, SH, $P(O)(OH)_n$,

$CONH(CH_2)_qNHCC$, 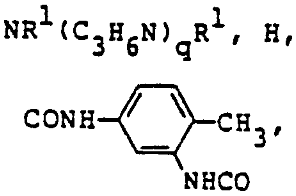, $NR^1R^2$, $OC(CH_2)_qCO$,

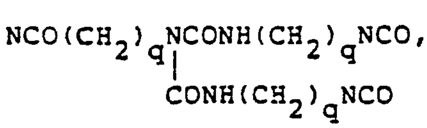 or 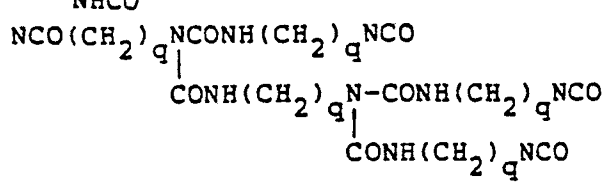

where q = 1—10, n = 0 or 1, and each of $R^1$ and $R^2$ is a hydrogen atom, an alkyl group or an aryl group. There is no particular restriction to the unsaturated ester containing a polyfluoroalkyl or polyfluoroether group having from 4 to 21 carbon atoms for forming the compound II or III. However, the following acrylates or methacrylates are preferred.

$CF_3(CF_2)_4CH_2OCOC(CH_3){=}CH_2$

$CF_3(CF_2)_6(CH_2)_2OCOC(CH_3){=}CH_2$

$CF_3(CF_2)_6COOCH{=}CH_2$

$CF_3(CF_2)_7CH_2CH_2OCOCH{=}CH_2$

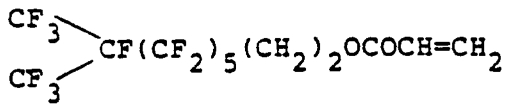

$CF_3(CF_2)_7SO_2N(C_3H_7)(CH_2)_2OCOCH{=}CH_2$

$CF_3(CF_2)_7(CH_2)_4OCOCH{=}CH_2$

$CF_3(CF_2)_7SO_2N(CH_3)(CH_2)_2OCOC(CH_3){=}CH_2$

$CF_3(CF_2)_7SO_2N(C_2H_5)(CH_2)_2OCOCH{=}CH_2$

$CF_3(CF_2)_7CONH(CH_2)_2OCOCH{=}CH_2$

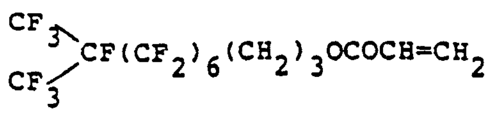

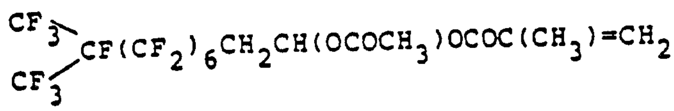

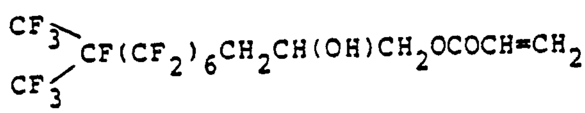

$CF_3(CF_2)_8(CH_2)_2OCOCH{=}CH_2$

$CF_3(CF_2)_8(CH_2)_2OCOC(CH_3){=}CH_2$

$CF_3(CF_2)_8CONH(CH_2)_2OCOC(CH_3){=}CH_2$

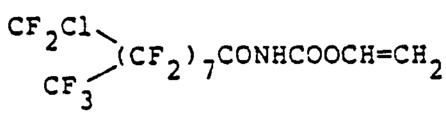

$H(CF_2)_{10}CH_2OCOCH{=}CH_2$

$CF_2Cl(CF_2)_{10}CH_2OCOC(CH_3){=}CH_2$

$C_3F_7OCFCF_3COOC_2H_4NHCOCH{=}CH_2$

$C_3F_7O(C_3F_6O)_2CFCF_3COOC_2H_4OCOCH{=}CH_2$

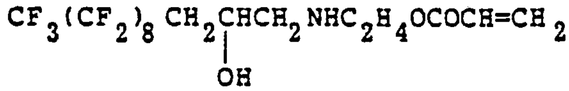

The compound II may be an epoxy compound such as

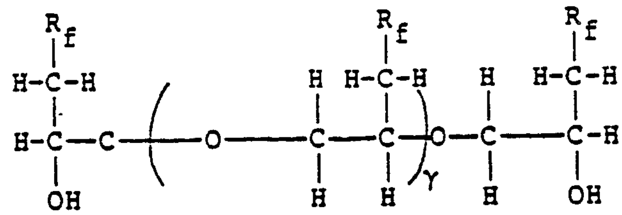

wherein γ is from 0 to 100.

The compound copolymerizable with the above unsaturated ester may be selected from a wide range of compounds so long as it does not adversely affect the method of the present invention. For instance, it is possible to copolymerize, as a constituting unit in the copolymer, one or more polymerizable compounds containing no perfluoroalkyl group, such as ethylene, vinyl acetate, vinyl chloride, vinyl fluoride, vinylidene halide, styrene, α-methylstyrene, p-methylstyrene, acrylic acid and its alkyl ester, methacrylic acid and its alkyl ester, poly(oxyalkylene)acrylate, poly(oxyalkylene)methacrylate, acrylamide, methacrylamide, diacetoneacrylamide, methyloldiacetone acrylamide, N-methylol acrylamide, vinyl alkyl ether, halogenated alkyl vinyl ether, vinyl alkyl ketone, butadiene, isoprene, chloroprene, glycidyl acrylate, benzyl methacrylate, benzyl acrylate, cyclohexyl acrylate, maleic anhydride, aziridinyl acrylate or methacrylate, and N-vinyl carbazole. The ratio for the copolymerization of such a copolymerizable component to the unsaturated ester containing the polyfluoroalkyl or polyfluoropolyether group is usually form 1 to 70% by weight, preferably from 10 to 50% by weight.

To obtain the compound II or III of the present invention, it is common to employ a solution polymerization wherein the starting material polymerizable compounds are dissolved in a proper organic solvent, and the polymerization is conducted by the action of the polymerization initiating source (e.g. a peroxide or an azo compound soluble in the organic solvent used, or an ionizing radiation). As a solvent suitable for the solution polymerization, there may be mentioned toluene, ethyl acetate, isopropyl alcohol, 1,1,2-trichloro-1,2,2-trifluoroethane, tetrachlorodifluoroethane or methylchloroform.

In the present invention, the above-mentioned compounds I, II and III may be employed alone or in combination as a mixture of two or more different kinds. In the case of a mixture of the compounds I, II and III, it is preferred to use the compound II as the major component, since the performance for the prevention of the penetration or deposition of the flux is thereby high. The fluorine content in the compound I, II or III is preferably at least 20% by weight, more preferably at least 50% by weight.

These compounds are dispersed in water or dispersed or dissolved in an organic solvent, and such as aqueous dispersion or organic solution is applied by spraying or brushing to the non-soldering surface, particularly to the portion where the flux is likely to penetrate to or deposit on. Otherwise, the treatment may be made by dipping the non-soldering surface in such as dispersion or solution. As the organic solvent, there may be mentioned a ketone such as acetone or methyl ethyl ketone, an ester such as methyl acetate, ethyl acetate or isoamyl acetate, and ether such as diethyl ether or dioxane, or a halogenated hydrocarbon such as methyl chloroform, trichloroethylene, tetrachloroethylene, tetrachlorodifluoroethane, 1,1,2-trichloro-1,2,2-trifluoroethane or methaxylene hexafluoride. These solvents may be used alone or in combination as a mixture of two or more different kinds. A spray composition may be prepared by adding a propellant such as dichloro-difluoromethane, monofluorotrichloromethane or dichlorotetrafluoroethane to the above solution and the mixture is filled in a proper container. It is advantageous to conduct spray treatment in that after the treatment, the composition immediately dries up and exhibits excellent prevention of the penetration or deposition of the flux. The amount of the compound I, II or III in the solvent or water is usually from 0.01 to 10% by weight, preferably from 0.1 to 2% by weight.

If the compound I, II or III is applied to the through-holes in a printed circuit board to form a coating of the compound, the flux will be prevented from penetrating via the through-holes to the side of the printed circuit board on which parts are to be mounted, whereby corrosion can be prevented. Further, when the soldering is applied to the terminals or lead wires from such parts as switches, capacitors, connectors or resistors, it is likely that the flux penetrates via the terminals or lead wires to the interior of such parts. Accordingly, when the flux contains a non-conductive component, a failure in the electric conduction is likely to be led in the interior of the parts. It is possible to prevent the penetration of the flux by forming the coating of the present invention at the peripheral portion around the soldering portion, e.g. in the vicinity of

the base portion from which the terminals or lead wires extend.

On the other hand, if the amount of the compond I, II or III in the organic solvent or water is adjusted to be as small as at most about 0.2% by weight and a thin coating is thereby formed, such as thin coating does not interfere with the soldering operation even if the coating is formed on the soldering portion. Thus, depending upon the thickness of the coating, the coating may be formed on the entire surface of the electrical product, i.e. not only on the non-soldering surface at the peripheral portion around the soldering portion, but also on the soldering portion, whereby the efficiency for the flux treatment may be improved. The formed coating brings about no adverse electrical effect, and may be retained as coated. However, it may readily be dissolved and removed with frons such as 1,1,2-trichloro-1,2,2-trifluoroethane which give no adverse effect to the material of the electrical product. The coating of the compound I, II or III has a function whereby the flux deposited on the coating can readily be removed without using any solvent, in addition to the above-mentioned function for preventing the penetration of the flux.

Now, the present invention will be described with reference to Examples. However, it should be understood that the present invention is by no means restricted by these specific Examples.

Examples

Each fluoro compound as identified in Table 1 was dissolved in 1,1,2-trifluoro-1,2,2-trichloroethane to obtain a 1 wt% solution. This solution was coated to the through-holes of a printed circuit board and dried at room temperature to form a coating of the fluoro compound. A soldering flux was put in a container to a depth of about 2 mm, and the printed circuit board was placed thereon so that the soldering surface side of the printed circuit board was located below and the parts-mounting surface side was located above, and left for one minute. One minute later, the penetration of the flux via the through-holes to the parts-mounting surface side was determined by the observation with naked eyes. The results are shown in Table 1.

Likewise, the above solution was coated to the base portion of a terminal extending outwardly from a switch, the base portion being in contact with the switch main body. The coated solution was dried at room temperature to form a coating of the fluoro compound. A soldering flux was coated to the forward end of the terminal to be soldered other than the base portion of the terminal on which the coating was formed. The penetration of the flux via the terminal to the interior of the switch was determined by the observation with naked eyes. The results are shown in Table 1.

| | Fluoro compound | Prevention of the penetration of flux | |
|---|---|---|---|
| | | Via through-holes | Via a terminal of a switch |
| Example | Homopolymer of $C_8F_{17}C_2H_4OCOCH{=}CH_2$ | Good | Good |
| Example | Copolymer of $CH_3$<br>$C_8F_{17}C_2H_4OCOC{=}CH_2/CH_2{=}CCl_2$ = 90/10 | " | " |
| Example | Copolymer of<br>$C_{10}F_{21}CONHC_2H_4OCOCH{=}CH_2/CH_2{=}CH$ = 80/20<br>$COOC_{12}H_{25}$ | " | " |
| Example | Copolymer of $C_6F_{13}SO_2NHC_2H_4OCOCH{=}CH_2/$<br>$C_3F_7O(C_3F_6O)_2CFCF_3COOC_2H_4OCOCH{=}CH_2$ = 70/30 | " | " |
| Example | $C_8F_{17}CONHC_2H_4NHCOC_8F_{17}$ | " | " |
| Example | $(C_{10}F_{21}C_2H_4O)_3P{=}O$ | " | " |
| Example | $C_6F_{13}C_2H_4OOCNH(CH_2)_3NCONH(CH_2)_3NHCOOC_2H_4C_6F_{13}$<br>$CONH(CH_2)_3NHCOOC_2H_4C_6F_{13}$ | " | " |
| Example | 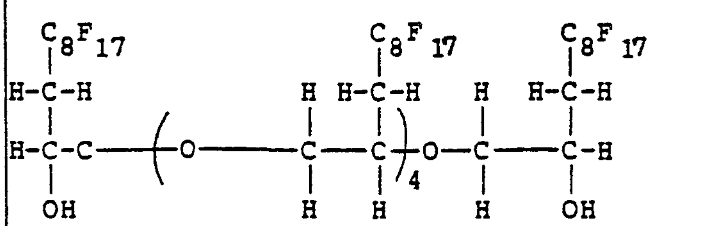 | " | " |
| Comparative Example | No treatment | Bad | Bad |

Evaluation standards:

Good: No flux penetrated

Bad: Penetration of the flux was observed.

## Claims

1. A method for soldering an electrical device with a soldering flux, wherein an aqueous dispersion or an organic solvent solution of a compound containing a polyfluoroalkyl or polyfluoroether group having from 4 to 21 carbon atoms is applied to a peripheral portion around the soldering portion and dried to form

a coating of said compound so as to prevent the soldering flux from penetration to or depositing on said peripheral portion.

2. The method according to Claim 1, wherein the compound containing a polyfluoroalkyl or polyfluoroether group having from 4 to 21 carbon atoms is a homopolymer of an acrylate or methacrylate containing a perfluoroalkyl or aliphatic perfluoropolyether group having from 4 to 21 carbon atoms, or a copolymer of the acrylate or methacrylate with other copolymerizable compound.

3. The method according to Claim 1, wherein the electrical device is a printed circuit board, an integrated circuit or a switch, capacitor, connector or resistor connected thereto.

4. The method according to Claim 1, wherein the coating of the compound containing a polyfluoroalkyl or polyfluoroether group having from 4 to 21 carbon atoms is formed on through-holes of a printed circuit so as to prevent the soldering flux from penetrating to the peripheral portion other than the soldering portion.

**Patentansprüche**

1. Verfahren zum Löten einer elektrischen Vorrichtung mit einem Löt-Flußmittel, wobei eine wäßrige Dispersion oder eine Lösung in einem organischen Lösungsmittel von einer Verbindung, enthaltend eine Polyfluoroalkyl- oder Polyfluorethergruppe mit 4 bis 21 Kohlenstoffatomen, auf einen peripheren Bereich um die Lötstelle herum appliziert und getrocknet wird unter Ausbildung einer Beschichtung aus dieser Verbindung, um so zu verhindern, daß das Löt-Flußmittel in den peripheren Bereich eindringt oder sich darauf abscheidet.

2. Verfahren gemäß Anspruch 1, wobei die Verbindung, enthaltend eine Polyfluoralkyl- oder Polyfluorethergruppe mit 4 bis 21 Kohlenstoffatomen, ein Homopolymerisat eines Acrylats oder Methacrylats, enthaltend eine Perfluoroalkyl- oder aliphatische Perfluorpolyethergruppe mit 4 bis 21 Kohlenstoffatomen, ist oder ein Copolymerisat des Acrylats oder Methacrylats mit anderer copolymerisierbarer Verbindung.

3. Verfahren gemäß Anspruch 1, wobei die elektrische Vorrichtung eine gedruckte Schaltkreistafel, eine integrierte Schaltung oder ein Schalter, Kondensator, Anschluß oder Widerstand ist, der daran angeschlossen ist.

4. Verfahren gemäß Anspruch 1, wobei die Beschichtung aus der Verbindung, enthaltend eine Polyfluoralkyl- oder Polyfluorethergruppe mit 4 bis 21 Kohlenstoffatomen, auf Durchgangslöchern einer gedruckten Schaltung in der Weise ausgebildet ist, daß ein Eindringen des Löt-Flußmittels in den peripheren Bereich mit Ausnahme der Lötstelle verhindert wird.

**Revendications**

1. Procédé de brasage d'un dispositif électrique avec un décapant de brasage, dans lequel on applique à la partie périphérique entourant la partie à braser, une dispersion aqueuse ou une solution, dans un solvant organique, d'un composé contenant un groupe polyfluoroalkyle ou polyfluoroéther, ayant de 4 à 21 atomes de carbone, et on la sèche pour former un revêtement dudit composé, de façon à empêcher le décapant de brasage de pénétrer dans, ou de se déposer sur, ladite partie périphérique.

2. Procédé selon la revendication 1, dans lequel le composé contenant un groupe polyfluoroalkyle ou polyfluoroéther, ayant de 4 à 21 atomes de carbone, est un homopolymère d'un acrylate ou méthacrylate contenant un groupe perfluoroalkyle ou perfluoropolyéther aliphatique, ayant de 4 à 21 atomes de carbone, ou un copolymère de l'acrylate ou du méthacrylate avec un autre composé copolymérisable.

3. Procédé selon la revendication 1, dans lequel le dispositif électrique est une plaque à circuits imprimés, un circuit intégré ou un interrupteur, un condensateur, un connecteur ou une résistance connectés à ceux-ci.

4. Procédé selon la revendication 1, dans lequel le revêtement du composé contenant un groupe polyfluoroalkyle ou polyfluoroéther, ayant de 4 à 21 atomes de carbone, est formé sur des trous traversants d'un circuit imprimé, de façon à empêcher le décapant de brasage de pénétrer dans la partie périphérique autre que la partie à braser.